Europäisches Patentamt

European Patent Office

Office européen des brevets

(11) Numéro de publication: **0 258 138 B1**

(12) **FASCICULE DE BREVET EUROPEEN**

(45) Date de publication de fascicule du brevet:
20.03.91

(51) Int. Cl.⁵: **H05K 13/04**

(21) Numéro de dépôt: 87401896.3

(22) Date de dépôt: 18.08.87

(54) **Dispositif de centrage de composants préformés en vue de leur implantation à plat par une machine de dépose automatique.**

(30) Priorité: 25.08.86 FR 8612042

(43) Date de publication de la demande:
02.03.88 Bulletin 88/09

(45) Mention de la délivrance du brevet:
20.03.91 Bulletin 91/12

(84) Etats contractants désignés:
CH DE FR GB IT LI NL SE

(56) Documents cités:
EP-A- 0 162 115
US-A- 3 358 852
US-A- 4 264 268

(73) Titulaire: OREGA ELECTRONIQUE & MECANI-
QUE
74, rue du Surmelin
F-75020 Paris(FR)

(72) Inventeur: Lobry, Claude
THOMSON-CSF SCPI 19, avenue de Messine
F-75008 Paris(FR)
Inventeur: Trutt, Didier
THOMSON-CSF SCPI 19, avenue de Messine
F-75008 Paris(FR)

(74) Mandataire: Chaverneff, Vladimir et al
THOMSON-CSF SCPI
F-92045 PARIS LA DEFENSE CEDEX 67(FR)

## Description

L'invention est relative à un dispositif de centrage de composants préformés en vue de leur implantation à plat par une machine de dépose automatique.

On utilise de plus en plus, notamment, lors de la réalisation des circuits électroniques haute-fréquence, la technique dite de l'implantation à plat des composants. Cette technique consiste à assurer le contact électrique du composant du côté où se trouve son corps, c'est-à-dire à placer le corps du composant et les connexions du côté du circuit imprimé où se trouvent les bandes conductrices. Contrairement à la technique dans laquelle le circuit imprimé est percé de trous pour le passage des broches ou des pattes du composant et dans laquelle le corps est placé du côté opposé à celui où sont assurées les connexions, cette technique permet de réduire les signaux parasites dus au rayonnement des extrémités des broches ou des pattes lorsque le circuit électronique est en fonctionnement.

En outre, la réalisation des circuits est de plus en plus automatisée mais les machines connues jusqu'alors ne permettent pas l'implantation à plat de tous les types de composants. En effet, certains composants tels que des circuits intégrés ont été prévus spécialement pour être implantés à plat et, dans un mode standard, ces composants comportent un boîtier sensiblement en forme de parallélépipède rectangle de base carrée ou rectangulaire. Sur la surface du côté du boîtier destiné à être en regard avec le circuit, c'est-à-dire le fond du boîtier, affleurent des éléments conducteurs pour assurer le contact entre la partie active du composant et le circuit imprimé. La fixation sur le circuit imprimé s'effectue soit à l'aide d'une colle conductrice et dans ce cas, ce sont les contacts qui sont enduits de colle, soit par l'intermédiaire du boîtier lui-même avec une colle plus classique.

D'autres composants destinés à être implantés à plat sont constitués également d'un boîtier, mais les moyens de connexion sont des broches ou des pattes qui sortent d'au moins un des côtés autres que le dessus ou le fond du boîtier. Ces broches ou ces pattes sont préformées pour que leur extrémité libre soit dans le plan du fond du boîtier afin que, lorsque le fond est sur le circuit imprimé, l'extrémité libre de chaque broche ou patte puisse être au contact d'une bande conductrice du circuit imprimé.

On réalise ainsi des diodes, des transistors, ou encore d'autres types de composants bâtis autour d'un boîtier sensiblement en forme de parallélépipède rectangle.

Lors d'une implantation automatique, c'est un bras qui prend les composants un par un et les place en des endroits déterminés.

Pour que la mise en place soit correcte, il faut que les composants soient bien positionnés par rapport au bras, ce qui implique qu'avant leur prise par le bras, ils soient centrés précisément. Ce centrage s'effectue à l'aide d'un dispositif faisant partie de la chaîne d'insertion qui est parfois monté en rotation pour orienter le composant d'une façon déterminée par rapport au bras manipulateur afin que la cinématique de ce dernier soit la plus simple possibles, voir par example EP-A-0162115.

Les composants sont placés sur le circuit à l'aide d'un autre bras manipulateur, ou de tout autre dispositif, qui vient les prendre dans un magasin approvisionneur comportant des alvéoles dans lesquelles les composants sont placés un par un. Le support est par exemple en forme de bande et les composants sont sortis des alvéoles par un organe de succion associé audit autre bras manipulateur.

C'est la phase de centrage qui présente des inconvénients et pose des problèmes auxquels a pour but de remédier la présente invention.

En effet, le centrage des composants de type standard s'effectue sur un plateau, éventuellement tournant pour l'orientation correcte par rapport au bras d'implantation. Le plateau est pourvu de deux paires de mors perpendiculaires entre elles pour venir serrer deux à deux les côtés du boîtier autre que le fond et le dessus. les mors de chaque paire serrant deux côtés opposés se déplacent ensemble et à la même vitesse relative l'un par rapport à l'autre. En conséquence, lorsque les quatre mors sont serrés, le composant est centré.

Un tel dispositif est inutilisable pour centrer des composants préformés car il implique que les mors prennent appui sur les pattes ou broches latérales, ce qui entraîne leur déformation. En conséquence, si un même magasin d'approvisionnement contient des composants des deux types, il faut prévoir pour le centrage deux machines différentes ou deux procédés différents.

L'invention se rapporte à un dispositif de centrage de composants encapsulés dans un boîtier de forme sensiblement parallélépipédique destinés à être implantés à plat, composants du type à deux côtés opposés pourvus chacun d'au moins une broch ou patte préformée, ce dispositif comportant deux paires de mors perpendiculaires entre elles, elle est caractérisée en ce que la première paire de mors effectue le centrage des composants selon un axe perpendiculaire à deux de leurs faces latérales ne comportant pas de broches, que la deuxième paire de mors est pourvue d'au moins un évidement de dimensions supérieures à celles des broches telles que les mors viennent au contact des côtés du boîtier sans venir au contact des broches.

Selon une autre caractéristique, lesdits évidements sont tels qu'ils permettent le centrage de composants sur lesquels ladite broche ou patte est préformée avec son extrémité libre dans le plan du fond du boîtier.

Le dispositif de l'invention est particulièrement avantageux car il peut être utilisé avec tous les types de composants prévus pour être implantés à plat, et notamment avec les diodes ou autres composants préformés en vue de leur utilisation sur des circuits haute fréquence.

D'autres caractéristiques et avantages de l'invention apparaîtront avec la description de quelques modes de réalisation faite en regard des figures annexées sur lesquelles:

- les figures 1a et 1b rappellent le principe de l'implantation à plat de composants;

- la figure 2 est un schéma de principe du dispositif de l'invention ;

- la figure 3 est une vue en perspective du dispositif de la figure 2.

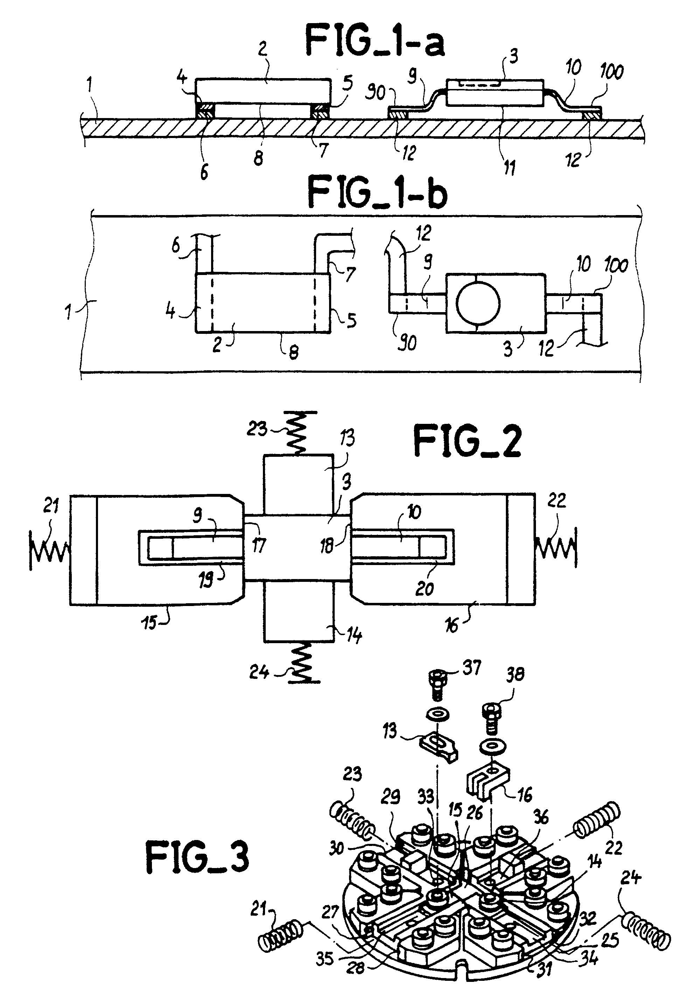

Sur les figures 1a et 1b, on a respectivement représenté de côté et de dessus, un circuit imprimé 1 sur lequel deux composants 2,3 sont implantés à plat.

Le premier 2 composant est un composant standard, c'est-adire dont les éléments conducteurs 4, 5 pour assurer la liaison avec des bandes conductrices 6,7 du circuit imprimé 1 sont sous le fond 8 de son boîtier.

Ce type de composant est centré facilement à l'aide des dispositifs connus à mors avant d'être pris par le bras d'implantation.

Le second composant 3 est par exemple une diode montée dans un boîtier de forme parallélépipédique.

Les dispositifs connus à mors ne permettent pas son centrage car ils écraseraient les pattes ou broches 9, 10 de connexion, faisant saillie ici de deux côtés opposés du boîtier autres que le fond il et le dessus. Lesdites pattes 9, 10 sont préformées de sorte que leurs extrémités libres 90, 100 soient dans le prolongement du plan du fond 11, afin qu'elles puissent venir au contact de bandes 12 conductrices du circuit imprimé.

Il est bien entendu que sur ces figures, on a fortement dilaté les dimensions pour mieux visualiser les éléments constitutifs.

La figure 2 montre, de dessus, le principe d'un mode de réalisation du dispositif conforme à l'invention pour permettre le centrage d'un composant préformé sans détériorer les pattes 9, 10 ou broches de connexion.

Sur cette figure, on a représenté le composant 3 des figures 1a et 1b et le dispositif pour le centrer.

Le dispositif est tout particulièrement adapté au centrage de composants dont deux côtés opposés sont pourvus chacun d'au moins une broche 9, 10 préformée.

Le dispositif comporte deux paires de mors 13, 14 et 15, 16 perpendiculaires entre elles. Afin d'éviter que les mors 15, 16 en regard des côtés où se trouvent les broches 9, 10 viennent les détériorer, ces mors sont agencés pour venir au contact des côtés 17, 18 du boîtier du composant d'où émergent les broches sans toucher auxdites broches.

Pour cela, les mors 15, 16 considérés sont pourvus sur toute leur hauteur, de préférence en leur centre, d'évidements 19, 20 réalisés par usinage, de dimensions supérieures à celles des broches, pour que celles-ci s'engagent dans lesdits évidements sans venir à leur contact et que les machoires desdits mors 15, 16 prennent appui sur les côtés 17, 18 du boîtier d'où émergent les broches.

Au cas ou un même côté est pourvu de plusieurs broches, si l'écartement entre ces broches le permet, on réalise autant d'évidements, pour que la surface de contact sur les côtés soit augmentée, sinon, on réalise un seul évidement dans lequel s'engage la totalité des broches d'un même côté. Dans ce dernier cas, les mors prennent appui à proximité des extrémités du côté.

Sur cette figure, on a représenté également des moyens de serrage des mors, que l'on a symbolisé par des ressorts 21, 22, 23, 24. Il est bien entendu qu'en fait, pour contrôler l'écartement et pour faire avancer simultanément les deux mors d'une même paire, il faut des moyens de couplage entre ces mors, lesquels moyens sont connus en soi dans les dispositifs de centrage des composants standards destinés à être implantés à plat.

Une opération de centrage d'un composant pourvu d'au moins deux broches réparties sur deux côtés opposés de son boîtier se déroule comme suit :

On commence par serrer les mors 13, 14 sur les côtés non munis de broches. Lorsqu'ils sont serrés, on est certain que les broches 9, 10 sur les autres côtés sont dans l'alignement des évidements destinés à les recevoir, et il suffit alors de serrer les mors 15, 16 pourvus de ces évidements. Aucun risque de déformation des broches n'est alors possible.

La figure 3 montre un dispositif complet de centrage conforme à l'invention.

Un plateau 25 sert de base à l'ensemble. Ce plateau peut être tournant pour permettre une fonction d'orientation complémentaire du centrage, afin de faciliter la cinématique du bras manipulateur de dépose sur le circuit imprimé.

Les mors 13, 14, 15, 16 sont, dans le mode de réalisation préféré, amovibles, ce qui permet, pour un même dispositif, de prévoir plusieurs jeux de mors, en fonction de la structure et/ou de la taille des composants à centrer. Le dispositif peut donc être utilisé exclusivement pour des circuits standards, avec des mors pleins, ou pour des circuits standards et des circuits préformés avec des mors évidés.

Une structure de guidage des mors est prévue sur le plateau 25, qui possède la forme de quatre guides perpendiculaires entre eux, au centre 26 desquels s'effectue le centrage. Les guides sont par exemple des paires de rails 27, 28, 29, 30, 31, 32 latéraux entre lesquels coulissent des chariots 33, 34, 35, 36 sur lesquels peuvent être fixés un par un les mors 13, 14, 15, 16 respectivement.

La fixation sur les chariots peut être assurée à l'aide de vis 37, 38.

Dans une variante, les ensembles mors chariot sont réalisés chacun dans une structure monobloc. Le changement d'un mors implique donc le changement du chariot.

Un avantage supplémentaire de l'invention réside dans le fait qu'elle peut être réalisée à peu de frais à partir d'un dispositif existant pour le centrage de composants standards en vue de leur montage en surface.

## Revendications

1. Dispositif de centrage de composants encapsulés dans un boîtier de forme sensiblement parallélépipédique, destinés à être implantés à plat, composants du type à deux côtés opposés pourvus chacun d'au moins une broche ou patte préformée (9,10), ce dispositif comportant deux paires de mors (13,14 et 15,16) perpendiculaires entre elles, caractérisé en ce que la première paire de mors (13,14) effectue le centrage des composants selon un axe perpendiculaire à deux de leurs faces latérales ne comportant pas de broches, que la deuxième paire de mors (15, 16) est pourvue d'au moins un évidement (19,20) de dimensions supérieures à celles des broches telles que les mors viennent au contact des côtés du boîtier sans venir au contact des broches.

2. Dispositif selon la revendication 1, caractérisé en ce que lesdits évidements (19,20) sont agencés pour permettre le centrage de composants (3) sur lesquels ladite broche ou patte (9,10) de connexion est préformée avec son extrémité libre (90,100) dans le plan du fond (11) du boîtier.

3. Dispositif selon la revendication 2, caractérisé en ce qu'un mors (13,14,15,16) destiné à être en regard d'un côté (17,18) muni d'au moins d'une broche ou patte (9,10) de connexion est pourvu d'au moins d'un évidement (19,20) dont les dimensions sont supérieures à celles de ladite broche (9,10) pour que celle-ci s'y engage sans venir au contact d'une partie du mors considéré.

4. Dispositif selon la revendication 3, caractérisé en ce qu il comporte deux mors (15,16) destinés à serrer deux côtés opposés (17,18) munis chacun d'au moins une broche ou patte (9,10) de connexion et en ce que lesdits mors (15,16) sont pourvus chacun d'au moins un évidement (19,20).

5. Dispositif selon l'une quelconque des revendications 1 à 4 précédentes, caractérisé en ce que les mors (13,14,15,16) sont chacun sur un chariot (33,34,35,36) guidé par des rails (27,28,29,30,31,32) latéraux, perpendiculaires entre eux deux à deux et portés sur un plateau (25).

6. Dispositif selon la revendication 5, caractérisé en ce que les mors sont amovibles par rapport aux chariots.

7. Dispositif selon la revendication 5, caractérisé en ce que les mors sont fixes par rapport aux chariots.

8. Dispositif selon l'une des revendications 1 à 7, caractérisé en ce que des moyens (21,22,23,24) sont prévus pour assurer le serrage simultané des deux mors d'une même paire.

9. Dispositif selon l'une des revendications 5 à 8, caractérisé en ce que le plateau (25) est tournant.

## Claims

1. A centering device for components encapsulated in a casing of substantially paralellepipedic shape and intended to be flatly mounted, said components belonging to the type having two opposing sides each provided with at least one preformed lug (9, 10), said device comprising two pairs of clamping yaws (13, 14 and 15, 16) disposed perpendicularly to one another, characterized in that the first pair of clamping yaws (13, 14) ensures the centering of the components along an axis which is perpendicular to two of their side faces devoid of lugs, and in that the second pair of clamping yaws (15, 16) is provided with at least one recess (19, 20) having dimensions which are greater than those of the lugs, such that the clamping yaws enter into contact with the side faces of the casing without touching the lugs.

2. A device according to claim 1, characterized in that said recesses (19, 20) are arranged for enabling the centering of the components (3) on which said connection lug (9, 10) is preformed in such a way that its free end (90, 100) is located in the plane of the bottom (11) of the casing.

3. A device according to claim 2, characterized in that a clamping yaw (13, 14, 15, 16) intended to face a side (17, 18) which carries at least one connection lug (9, 10), is provided with at least one recess (19, 20) whose dimensions are greater than those of said lug (9, 10), so as to allow the lug to enter therein without touching a portion of the considered clamping yaw.

4. A device according to claim 3, characterized in that it comprises two clamping yaws (15, 16) intended to clamp two opposing sides (17, 18) each of which is provided with at least one connection lug (9, 10), and in that said clamping yaws (15, 16) are provided each with at least one recess (19, 20).

5. A device according to any one of the preceding claims 1 to 4, characterized in that the clamping yaws (13, 14, 15, 16) are each disposed on a slide (33, 34, 35, 36) guided by lateral rails (27, 28, 29, 30, 31, 32) disposed perpendicularly with one another by pairs and carried on a base plate (25).

6. A device according to claim 5, characterized in that the clamping yaws are movable relative to the slides.

7. A device acccording to claim 5, characterized in that the clamping yaws are stationary relative to the slides.

8. A device according to any one of the claims 1 to 7, characterized in that means (21, 22, 23, 24) are provided to ensure the simultaneous clamping of two clamping yaws of a same pair.

9. A device according to any one of claims 5 to 8, characterized in that the base plate (25) is a rotary plate.

**Ansprüche**

1. Zentriervorrichtung für Bauelemente, die in einem im wesentlichen parallelepipedischen Gehäuse eingeschlossen sind und flach montiert werden, wobei die Bauelemente zu dem Elementtyp gehören, der an zwei einander gegenüberliegenden Seiten mit je mindestens einer vorgeformten Anschlußfahne (9, 10) versehen ist, und wobei die Vorrichtung mindestens zwei senkrecht zueinander stehende Spannbackenpaare (13, 14 und 15, 16) aufweist, dadurch gekennzeichnet, daß das erste Paar Spannbacken (13, 14) die Zentrierung der Bauelemente entlang einer Achse bewirkt, die senkrecht zu zwei anschlußfahnenfreien Seitenflächen steht, und daß das zweite Paar Spannbacken (15, 16) mit mindestens einer Ausnehmung (19, 20) versehen ist, deren Abmessungen größer als die der Anschlußfahnen sind, derart, daß die Spannbacken in Berührung mit der Gehäuseseite kommen, ohne die Anschlußfahnen zu berühren.

2. Vorrichtung nach Anspruch 1, dadurch gekennzeichnet, daß die Ausnehmungen (19, 20) für die Zentrierung der Bauelemente (3) ausgelegt sind, an denen die Anschlußfahne (9, 10) so vorgeformt ist, daß ihr freies Ende (90, 100) in der Ebene des Bodens (11) des Gehäuses liegt.

3. Vorrichtung nach Anspruch 2, dadurch gekennzeichnet, daß eine Spannbacke (13, 14, 15, 16), die einer mit mindestens einer Anschlußfahne (9, 10) ausgestatteten Seite (17, 18) gegenüberstehen soll, mit mindestens einer Ausnehmung (19, 20) versehen ist, deren Abmessungen größer als die der Anschlußfahne (9, 10) sind, damit diese in sie eindringt, ohne mit einem Teil der betreffenden Spannbacke in Berührung zu kommen.

4. Vorrichtung nach Anspruch 3, dadurch gekennzeichnet, daß sie zwei Spannbacken (15, 16) zum Einklemmen zweier einander gegenüberliegender und jeweils mit mindestens einer Anschlußfahne (9, 10) versehener Seiten (17, 18) aufweist und daß die Spannbacken (15, 16) je mit mindestens einer Ausnehmung (19, 20) versehen sind.

5. Vorrichtung nach einem beliebigen der vorhergehenden Ansprüche 1 bis 4, dadurch gekennzeichnet, daß sich die Spannbacken (13, 14, 15, 16) je auf einem durch seitliche Schienen (27, 28, 29, 30, 31, 32) geführten Schlitten (33, 34, 35, 36) befinden, wobei die Schienen paarweise zueinander senkrecht verlaufen und von einer Grundplatte (25) getragen werden.

6. Vorrichtung nach Anspruch 5, dadurch gekennzeichnet, daß die Spannbacken relativ zu den Schlitten beweglich sind.

7. Vorrichtung nach Anspruch 5, dadurch gekennzeichnet, daß die Spannbacken relativ zu den Schlitten feststehen.

8. Vorrichtung nach einem der Ansprüche 1 bis 7, dadurch gekennzeichnet, daß Mittel (21, 22, 23, 24) vorgesehen sind, die das gleichzeitige Festklemmen der beiden Klemmbacken derselben Paare bewirken.

9. Vorrichtung nach einem der Ansprüche 5 bis 8, dadurch gekennzeichnet, daß die Grundplatte (25) drehbar ist.

# FIG_1-a

# FIG_1-b

# FIG_2

# FIG_3